# EUROPEAN PATENT SPECIFICATION

(11) **EP 1 087 428 B1**
(45) Date of publication and mention of the grant of the patent: **21.05.2008**
(21) Application number: 00912945.3
(22) Date of filing: 29.03.2000
(51) Int. Cl.: H01L 21/208, C01B 33/02

(54) **Method for forming a silicon film and ink composition for inkjet printer**
Verfahren zur Herstellung einer Siliziumschicht und Tintenstrahlzusammensetzung für Tintenstrahldrucker
Procédé de formation d'un film de silicium et composition d'encre pour imprimante à jet d'encre

(30) Priority: 30.03.1999 JP 9031199
(43) Date of publication of application: 28.03.2001
(73) Proprietor: Seiko Epson Corporation, Tokyo 160-0811 (JP); JSR Corporation, Tokyo 104-0045 (JP)
(72) Inventor: SEKI, Shunichi, Seiko Epson Corporation, Suwa-shi, Nagano 392-8502 (JP); SHIMODA, Tatsuya, Suwa-shi, Nagano 392-8502 (JP); MIYASHITA, Satoru, Suwa-shi, Nagano 392-8502 (JP); FURUSAWA, Masahiro, Suwa-shi, Nagano 392-8502 (JP); YUDASAKA, Ichio, Suwa-shi, Nagano 392-8502 (JP); MATSUKI, Yasuo, Chuo-ku, Tokyo 104-0045 (JP); TAKEUCHI, Yasumasa, Chuo-ku, Tokyo 104-0045 (JP)
(74) Representative: Sturt, Clifford Mark
(86) International application number: PCT/JP2000/001987
(87) International publication number: WO 2000/059014

(56) References cited:
- EP-A- 0 855 614
- JP-A- 3 215 941
- JP-A- 5 144 741
- JP-A- 6 191 821
- JP-A- 7 267 621
- JP-A- 8 008 179
- JP-A- 10 321 536
- JP-A- 11 079 727
- US-A- 4 695 331
- US-A- 4 728 528
- PATENT ABSTRACTS OF JAPAN vol. 015, no. 296 (P-1231), 26 July 1991 (1991-07-26) & JP 03 102324 A (SANYO ELECTRIC CO LTD), 26 April 1991 (1991-04-26)
- PATENT ABSTRACTS OF JAPAN vol. 018, no. 542 (C-1261), 17 October 1994 (1994-10-17) & JP 06 191821 A (SHOWA DENKO KK), 12 July 1994 (1994-07-12)

## Description

### TECHNICAL FIELD

The present invention relates to an ink composition containing a silicon precursor for forming by patterning a silicon film by an ink jet process in use of LSIs, thin film transistors, and photosensitive devices, and to a method for forming a silicon film by an ink jet process.

### BACKGROUND ART

As conventional methods for forming amorphous silicon films and polysilicon films, thermal CVD (chemical vapor deposition) processes, plasma enhanced CVD processes, and photo-assisted CVD processes using monosilane gas and disilane gas have been used. In general, thermal CVD processes are widely used for polysilicon films (refer to J. Vac. Sci. Technology, Vol. 14, 1082 (1977)), and plasma enhanced CVD processes are widely used for amorphous silicon films (refer to Solid State Com., Vol. 17, 1193 (1975)). These are used in production of liquid crystal devices having thin film transistors and solar batteries.

In the formation of silicon films by these CVD processes, however, further improvements are needed with regard to the following problems. (1) The production yield is low due to system contamination and the formation of foreign materials, which are caused by silicon particles generated during the gas phase reaction. (2) A uniform film thickness is barely obtainable on a substrate having an uneven surface due to gaseous raw materials. (3) The productivity is low due to a low deposition rate of the film. (4) The plasma enhanced CVD process requires a complicated and expensive radio frequency generator and vacuum equipment.

In regard to materials used in the CVD method, use of silicon hydride, which is highly reactive gas, causes difficulty in handling and requires hermetic vacuum equipment. Since these apparatuses are complicated, the apparatuses themselves are expensive. Moreover, the vacuum system and the plasma system consume a large amount of energy, resulting in high production costs.

In recent years, a method has been proposed for applying liquid silicon hydride with no vacuum system. Japanese Unexamined Patent Application Publication No. 1-29661 discloses a method for forming a silicon-based thin film in which a gaseous material is liquefied and is adsorbed onto a cooled substrate to react with chemically active, atomic hydrogen. This method, however, has the following problems. (1) Since silicon hydride is required as the raw material for the process and is continuously gasified and cooled, a complicated apparatus is required and the control of the thickness is difficult.

An example of solid silicon hydride polymers is reported in Great Britain Patent No. GB-2,077,710A. Since this polymer is insoluble in solvents, the film is not formed by coating.

Moreover, Japanese Unexamined Patent Application Publication No. 9-237927 discloses a method for spray-coating a polysilane solution onto a substrate having a large area and for pyrolyzing the coating to form a silicon film, in order to produce solar batteries. In carbon-containing silicon compounds, a large amount of carbon remains as an impurity in pyrolysis or photolysis by ultraviolet irradiation, hence, it is difficult to prepare an amorphous or polycrystalline silicon film having superior electrical characteristics.

The silicon semiconductor film is generally doped with a Group III element or a Group V element in the Periodic Table and is used as a p-type or n-type semiconductor. After the formation of the silicon film, doping using these elements is generally performed by thermal diffusion and ion implantation. Since the doping is performed *in vacuo*, process control is complicated, and it is particularly difficult to form a uniformly doped silicon film onto a large substrate.

On the other hand, the above Japanese Unexamined Patent Application Publication No. 9-237927 discloses a method for applying a polysilane solution containing an alkyl compound which imparts p-type or n-type conductivity and a method for pyrolyzing a coating film from a polysilane solution in an atmosphere containing a dopant source. In the former method, however, a uniformly doped film may be unobtainable due to differences in solubility between the polysilane and the dopant-containing alkyl compound, and the final film product inevitably contains a large amount of carbon as an impurity due to carbon contained in the material, as described above. In the latter method, it is difficult to control the dopant.

In a conventional method for forming a silicon film pattern, a silicon film is formed on the entire substrate by the above method, and a required pattern is formed by a photolithographic process or an etching process. When the silicon film is patterned over a large area to form many devices, many production steps must be employed and expensive apparatuses and various materials are used with a large amount of energy, resulting in high production costs.

EP 855 614 discloses a method of forming a silicon film by applying an ink composition containing a silicon compound onto a substrate by an inkjet process.

### DISCLOSURE OF INVENTION

It is an object of the present invention to provide a composition, which is a material for stably forming a desired silicon film pattern with low energy consumption at low cost, and a method for forming a silicon film without a conventional vacuum process, photolithography, and etching, in the production of a device having a desired silicon film pattern onto a substrate having a large area. It is another object to provide a composition containing a silicon precursor and a method for patterning a silicon film, in the production of a device having a silicon film doped with boron or phosphorus in which a film comprising a modified silicon compound as a silicon precursor is formed using a solution, and the silicon precursor film is converted into semiconductive silicon and doping is simultaneously achieved by heat and/or light treatment in an inert atmosphere.

According to the present invention, there is provided a method for forming a silicon film comprising: applying an ink composition including a silicon compound that is represented by the following general formula: SiₐX_{b}Y_{c}
wherein X represents a hydrogen atom and/or a halogen atom, Y represents a boron atom or a phosphorus atom, a represents an integer of 3 or more, b represents an integer of a to 2a+c+2, and c represents an integer of 1 to a.

Moreover, the present inventors have intensively researched to achieve the above objects and have discovered that an ink material composition containing a silicon compound represented by the following general formula above exhibits superior material stability, discharge stability, and coating uniformity in an ink jet process, and that the required silicon film pattern can be formed on a substrate by heat and/or light treatment of a silicon precursor coating film from the solution, with satisfactory conversion into the silicon film without incorporation of a solvent.

According to a further aspect of the present invention, there is provided an inkjet composition for forming a silicon film comprising a silicon compound represented by the following general formula

SiₐX_{b}Y_{c}

wherein X represents a hydrogen atom and/or a halogen atom, Y represents a boron atom or a phosphorus atom, a represents an integer of 3 or more, b represents an integer of a to 2a+c+2, and c represents an integer of 1 to a.

According to the present invention, there is provided a liquid composition containing a silicon compound for ink jet processes comprising a silicon compound represented by the general formula SiₐX_{b}Y_{c}, and a solvent for dissolving the silicon compound, the solvent having a specific viscosity, a specific surface tension, and a specific solid component content.

### BRIEF DESCRIPTION OF THE DRAWINGS

Fig. 1 is a drawing showing patterning steps of a silicon thin film by an ink jet process in accordance with Example 1.
Fig. 2 is a drawing showing patterning steps of a silicon thin film by an ink jet process in accordance with Example 2.
Fig. 3 is a drawing showing patterning steps of a p-type silicon thin film by an ink jet process in accordance with Example 3.
Fig. 4 is a drawing showing patterning steps of an n-type silicon thin film by an ink jet process in accordance with Example 4.
Fig. 5 is a drawing showing patterning steps of a silicon thin film by an ink jet process in accordance with Example 5.
Fig. 6 is a drawing showing patterning steps of a p-type silicon thin film by an ink jet process in accordance with Example 6.
Fig. 7 is a drawing showing patterning steps of a silicon thin film by an ink jet process in accordance with Example 7.

The embodiments of the present invention will be described in detail. The silicon compounds represented by the general formula (I) SiₙXₘ wherein n represents an integer 3 or more, m represents an integer of n, 2n-2, 2n, or 2n+2, and X represents a hydrogen atom and/or a halogen atom, do not form part of the present invention and are disclosed as examples only.

The silicon compounds used in the method for forming the silicon film in the present invention are preferably compounds represented by the general formula (II) SiₐX_{b}Y_{c} wherein X represents a hydrogen atom or a halogen atom, Y represents a boron atom or a phosphorus atom, a represents an integer of 3 or more, b represents an integer of a to 2a+c+2, and c represents an integer of 1 to a.

In these general formulae (I) and (II), n represents an integer of 3 or more, and a+c represents an integer of 4 or more. In consideration of thermodynamic stability, solubility, and feasibility of purification, cyclic silicon compounds with n of approximately 5 to 20 and particularly 5 or 6 are preferred in the general formula (I), and silicon compounds with a+c of approximately 5 to 20 and particularly 5 or 6 are preferred in the general formula (II). At a value of less than 5, the silicon compound is unstable due to distortion of the ring and handling is difficult. When n and a+c are larger than 20, the solubility decreases due to cohesive force of the silicon compound and selectable solvents are limited.

In the general formulae (I) and (II) for the silicon compounds, X represents a hydrogen atom and/or a halogen atom. Since these silicon compounds are precursors for the silicon films, these must be finally converted into amorphous or polycrystalline silicon by heat and/or light treatment. During the final conversion process, the silicon-hydrogen bonds and the silicon-halogen bonds are cleaved to form silicon-silicon bonds, and converted into silicon. Examples of halogen atoms are a fluorine atom, a chlorine atom, a bromine atom, and an iodine atom. Chlorine and bromine are preferable with regard to the bond cleavage. X may be a hydrogen atom alone or a halogen atom alone, or may be a partially halogenated compound in which the sum of hydrogen atoms and halogen atoms satisfies the general formula (I) or (II).

Examples of the silicon compounds represented by the general formula SiₙXₘ will be described. Examples of the compounds of m = 2n+2 include silane hydrides, such as trisilane, tetrasilane, pentasilane, hexasilane, and heptasilane, and substituted compounds thereof in which hydrogen atoms are partially or completely replaced with halogen atoms. Examples of m= 2n include monocyclic silicon hydride compounds, such as cyclotrisilane, cyclotetrasilane, cyclopentasilane, silylcyclopentasilane, cyclohexasilane, silylcyclohexasilane, and cycloheptasilane; and halogenated cyclic silicon compounds thereof in which hydrogen atoms are partially or completely replaced with halogen atoms, such as hexachlorocyclotrisilane, trichlorocyclotrisilane, soctachlorocyclotetrasilane, tetrachlorocyclotetrasilane, decachlorocyclopentasilane, pentachlorocyclopentasilane, dodecachlorocyclohexasilane, hexachlorocyclohexasilane, tetradecachlorocycloheptasilane, heptachlorocycloheptasilane, hexabromocyclotrisilane, tribromocyclotrisilane, pentabromocyclotrisilane, tetrabromocyclotrisilane, octabromocyclotetrasilane, tetrabromocyclotetrasilane, decabromocyclopentasilane, pentabromocyclopentasilane, dodecabromocyclohexasilane, hexabromocyclohexasilane, tetradecabromocycloheptasilane, and heptabromocycloheptasilane. Examples of compounds of m= 2n-2 include dicyclic silicon hydride compounds, such as 1,1'-biscyclobutasilane, 1,1'-biscyclopentasilane, 1,1'-biscyclohexasilane, 1,1'-biscycloheptasilane, 1,1'-cyclobutasilylcyclopentasilane, 1,1'-cyclobutasilylcyclohexasilane, 1,1'-cyclobutasilylcycloheptasilane, 1,1'-cyclopentasilylcyclohexasilane, 1,1'-cyclopentasilylcycloheptasilane, 1,1'-cyclohexasilylcycloheptasilane, spiro[2,2]pentasilane, spiro[3,3]heptasilane, spiro[4,4]nonasilane, spiro[4,5]decasilane, spiro[4,6]undecasilane, spiro[5,5]undecasilane, spiro[5,6]dodecasilane, and spiro[6,6]tridecasilane; substituted silicon compounds in which hydrogen atoms are partly or completely replaced with SiH₃ groups or halogen atoms. Moreover, examples of compounds of m= n include polycyclic silicon hydride compounds, such as Compounds 1 to 5 represented by the following formulae, and substituted silicon compounds thereof in which hydrogen atoms are partially or completely replaced with SiH₃ groups or halogen atoms. These compounds may be used as a mixture of two or more types.

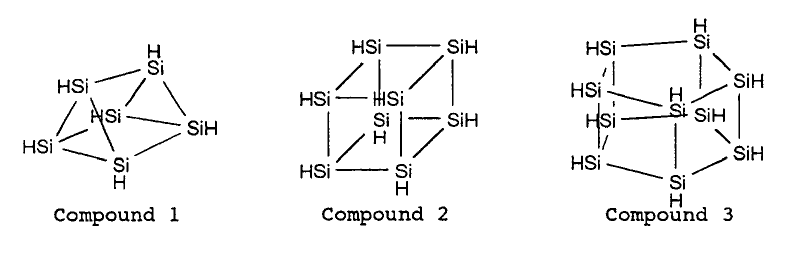

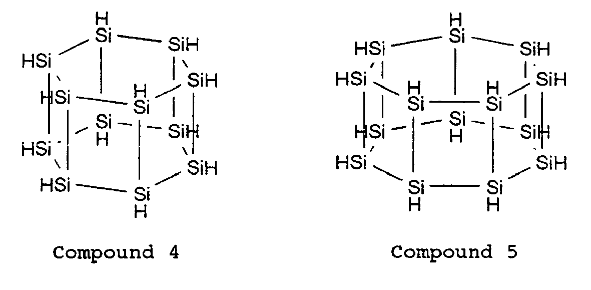

Examples of the compounds represented by the general formula (II) SiₐX_{b}Y_{c} used in the present invention include modified silane compounds as shown in Compounds 6 to 27 represented by the following formulae.

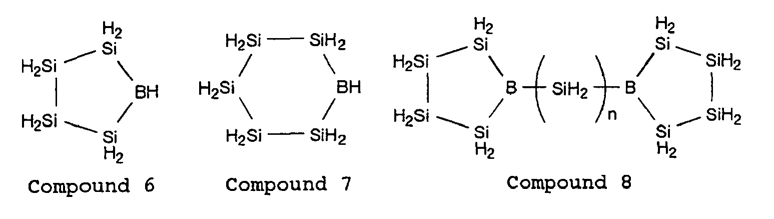

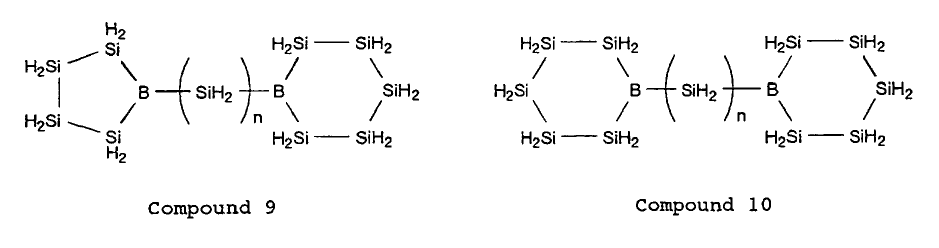

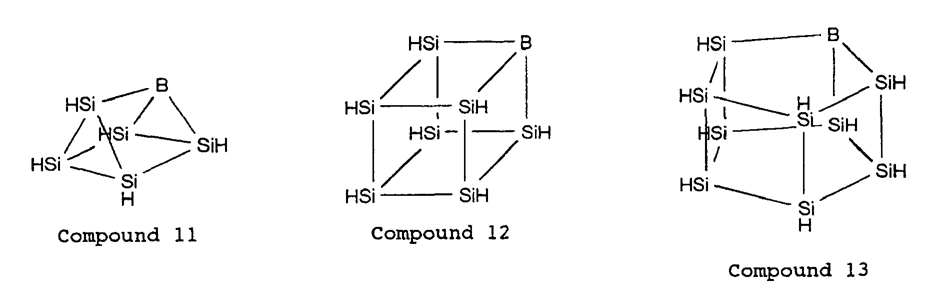

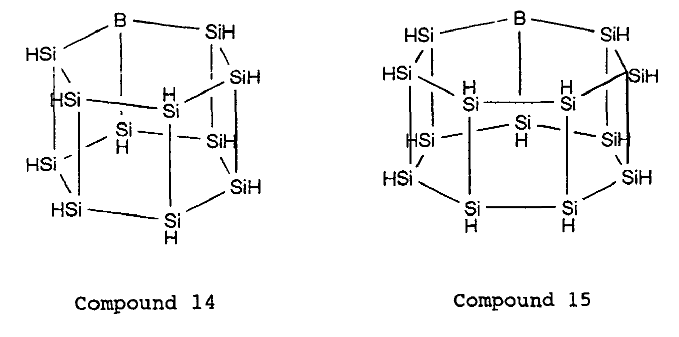

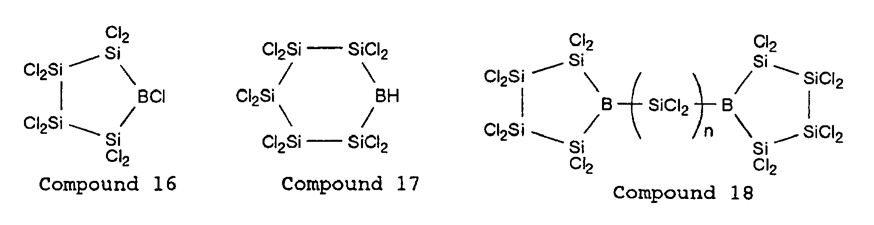

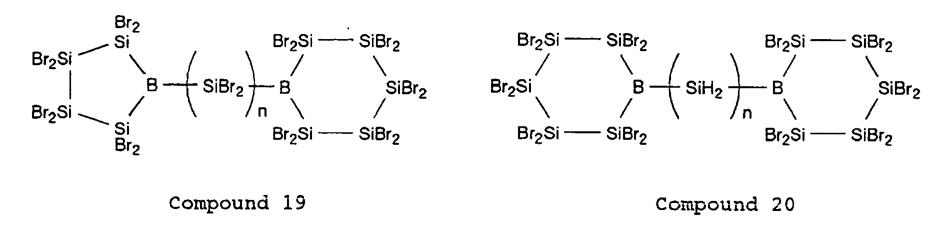

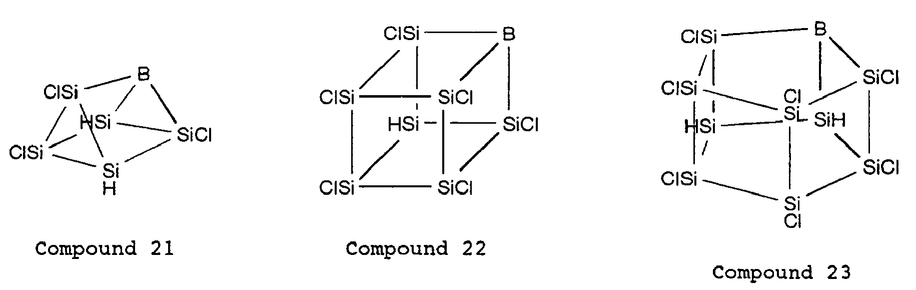

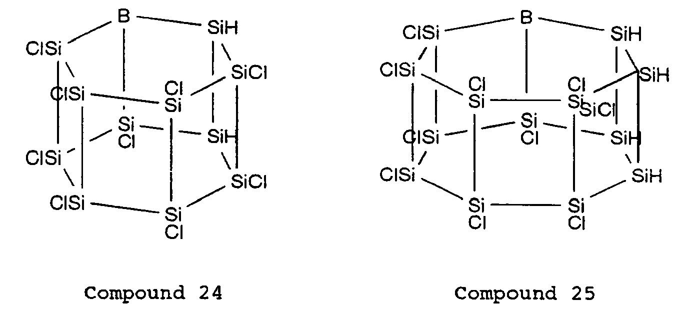

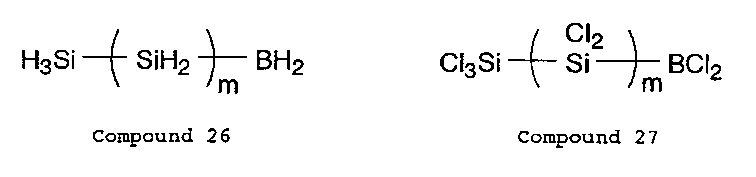

Herein, n in Compounds 8, 9, 10, 18, 19, and 20 represents an integer of 0 or more, and m in Compounds 26 and 27 represents an integer of 2 or more. In these formulae, boron-modified silane compounds are shown. Phosphorus-modified silane compounds also have similar backbones to those of the boron-modified silane compounds.

In the present invention, the above modified silane compounds may be used alone as a solution, or may be used as a mixture together with the above unmodified silane compounds. The ratio of the modified silane compound to the unmodified silane compound depends on the boron or phosphorus content as a modifying element, and the modifying element is 1 ppb to 25% to silicon atoms.

In the present invention, a solution in which the above silicon compound dissolved in a solvent is applied to an ink jet process. The vapor pressure of the solvent used in the present invention is preferably in a range of 0.001 to 50 mmHg. A vapor pressure exceeding 50 mmHg readily causes nozzle clogging due to drying of droplets discharged by the ink jet process, and will preclude stable discharge. A vapor pressure of less than 0.001 mmHg causes delayed drying of discharged ink. Since the solvent tends to remain in the silicon compound, a high quality silicon film is barely obtained after the heat and/or light treatment in the subsequent step.

Solvents used in the present invention are not limited as long as these can dissolve the silicon compounds and are unreactive with the compounds. Examples of the solvents include hydrocarbon solvents, such as n-heptane, n-octane, decane, toluene, xylene, cymene, durene, indene, dipentene, tetrahydronaphthalene, decahydronaphthalene, and cyclohexylbenzene; ether solvents, such as ethylene glycol dimethyl ether, ethylene glycol diethyl ether, ethylene glycol methyl ethyl ether, diethylene glycol dimethyl ether, diethylene glycol diethyl ether, diethylene glycol methyl ethyl ether, and p-dioxane; and polar solvents, such as propylene carbonate, γ-butyrolactone, N-methyl-2-pyrrolidone, dimethylformamide, dimethyl sulfoxide, and cyclohexanone. Among these, hydrocarbon solvents and ether solvents are preferable in view of solubility of silicon compounds and stability thereof. The hydrocarbon solvents are more preferable. These solvents may be used alone or in combinations of two or more. In particular, the hydrocarbon solvents are advantageous, since these exhibit high solubility of the silicon compounds and suppress the remaining silicon compound after the heat treatment and the light treatment, described below.

In the present invention, the ink composition (solution) applied to the ink jet process is prepared by mixing the above silicon compounds and/or the modified silicon compounds as solutes with the above solvents. The concentration of the solutes are determined depending on the required thickness of the silicon film. Preferably, the concentration is 0.01 to 10 percent by weight. When the concentration is less than 0.01%, a uniform coating film is not obtained and discharge operations must be increased. When the concentration exceeds 10%, the viscosity increases and affects discharge.

These solvents may contain a surface tension modifier, such as a fluorine type, a silicon type, or a nonionic type, in a trace amount, if necessary, within a range which does not impair required functions. The nonionic surface tension modifier improves wettability to a workpiece for applying the solution and leveling of the coating film, and prevents graininess and other imperfections, for example, an orange peel surface, of the coating film.

Examples of such nonionic surfactants include fluorinated surfactants having fluoroalkyl groups or perfluoroalkyl groups, and polyether alkyl surfactants having oxyalkyl groups. Examples of fluorinated surfactants include C₉F₁₉CONHC₁₂H₂₅, C₈F₁₇SO₂NH-(C₂H₄O)₆H, C₉F₁₇O-(PLURONIC L-35)-C₉F₁₇, C₉F₁₇O-(PLURONIC P-84)-C₉F₁₇, and C₉F₇O-(TETRONIC-704)-(C₉F₁₇)₂, wherein PLURONIC L-35 is a polyoxypropylene-polyoxyethylene block copolymer having an average molecular weight of 1,900 made by Asahi Denka Kogyo K.K., PLURONIC P-84 is a polyoxypropylene-polyoxyethylene block copolymer having an average molecular weight of 4,200 made by Asahi Denka Kogyo K.K., and TETRONIC-704 is an N,N,N',N'-tetrakis(polyoxypropylene-polyoxyethylene) block copolymer having an average molecular weight of 5,000 made by Asahi Denka Kogyo K.K.

Actual examples of the fluorinated surfactants include Efftop EF301, Efftop EF303, and Efftop EF352 made by Shin Akita Kasei K.K.; Megafack F171 and Megafac F173 made by Dainippon Ink and Chemicals; Asahi Guard AG710 made by Asahi Glass Co., Ltd.; Fluorad FC-170C, Fluorad FC430, and Fluorad FC431 made by Sumitomo 3M Limited; Surflon S-382, Surflon SC101, Surflon SC102, Surflon SC103, Surflon SC104, Surflon SC105, and Surflon SC106 made by Asahi Glass Co., Ltd.; BM-1000 and BM-1100 made by B. M-Chemie; and Schsego-Fluor made by Schwegmann.

Polyether alkyl surfactants are polyoxyethylene alkyl ethers, polyoxyethylene allyl ether, polyoxyethylene alkylphenol ethers, polyoxyethylene fatty acid esters, sorbitan fatty acid esters, polyoxyethylene sorbitan fatty acid ethers, and oxyethylene-oxypropylene block copolymers.

Actual examples of these polyether alkyl surfactants include Emulgen 105, Emulgen 430, Emulgen 810, Emulgen 920, Rheodol SP-40S, Rheodol TW-L120, Emanol 3199, Emanol 4110, Excel P-40S, Bridge 30, Bridge 52, Bridge 72, Bridge 92, Arlacel 20, Emasol 320, Tween 20, Tween 60, and Merge 45 made by Kao Corporation; and Nonipol 55 made by Sanyo Chemical Industries, Ltd. Examples of other nonionic surfactants include polyoxyethylene fatty acid esters, polyoxyethylene sorbitan fatty acid esters, and polyalkylene oxide block copolymers. Actual Examples of these surfactants are Chemistat 2500 made by Sanyo Chemical Industries, Ltd., SN-EX9228 made by San Nopco Limited, and Nonal 530 made by Toho Chemical Industry Co., Ltd.

It is preferable that the viscosity of the prepared silicon-compound-containing solution be within a range of 1 to 50 mPa·s. When the viscosity is lower than 1 mPa·s, the peripheral section of the nozzle in the ink jet process is readily contaminated due to overflow of the ink. When the viscosity is higher than 50 mPa·s, the frequency of nozzle clogging increases to preclude smooth discharge of droplets.

Preferably, the surface tension of the silicon-compound-containing solution is in a range of 20 to 70 dyn/cm. A surface tension of less than 20 dyn/cm causes increased wettability of the ink composition to the nozzle surface, resulting in nonlinear flight. A surface tension exceeding 70 dyn/cm causes an unstable meniscus shape at the nozzle tip, resulting in uncontrollability of the discharged volume and discharging timing of the ink composition.

The droplet discharge apparatus in the ink jet process used for supplying the solution in the present invention may be of any mechanism which can discharge appropriate droplets in constant volumes. The apparatus may be of an ink jet process using a piezoelectric element which can form droplets, each weights approximately several tens nanograms, or of a bubble jet process which forms bubbles by thermal energy from a heater. Moreover, a general coating process, such as spin coating, dip coating, spray coating, roll coating, or curtain coating, may be combined, if necessary. When the ink composition containing the silicon precursor is applied by the ink jet process, the atmosphere is generally an inert gas, such as argon, helium, or nitrogen, and the temperature is appropriately selected in a range of room temperature to approximately 100°C depending on the ink characteristics.

In the present invention, the substrate used in discharge of the silicon-compound-containing solution by the ink jet process is not limited. Examples of the substrates include general quartz, borosilicate glass, soda glass, transparent electrodes such as ITO, metallic substrates, e.g., gold, silver, copper, nickel, titanium, aluminum, and tungsten, and glass or plastic substrates coated with these metals.

The coating film of the silicon-compound-containing solution formed by the ink jet process is subjected to a heat and/or light treatment. The treatment is performed in an inert gas atmosphere, such as nitrogen, argon, and helium. A small amount of reducing gas such as hydrogen may be added, if necessary. The heat treatment is performed for the removal of the solvent and the conversion into a metallic silicon film, after the coating of the ink (solution). The drying treatment may be appropriately determined by the boiling point (vapor pressure) and the pressure of the solvent and thermal behavior of the silicon compound, without particular limitation. The conversion into the metallic silicon film is generally performed in an argon atmosphere at approximately 100 to 800°C, preferably approximately 200 to 600°C, and more preferably 300°C to 500°C. In general, an amorphous silicon film is obtained at a final temperature of 550°C or less, whereas a polycrystalline silicon film is obtained at a higher temperature. At a final temperature of less than 300°C, pyrolysis of the silicon compound does not sufficiently proceed, and a silicon film having a sufficient thickness cannot be formed in some cases. The polycrystalline silicon film may also be prepared by conversion of the above amorphous silicon film into the polycrystalline silicon by laser irradiation. The atmosphere in the laser irradiation is preferably an inert gas, such as helium and argon, and may contain a reducing gas such as hydrogen.

The coating film of the silicon compound formed by the ink jet process in the present invention may be subjected to a light treatment in an inert gas atmosphere before and/or after removing the solvent in the coating film. The silicon compound soluble in solvents is converted into a tough coating film, which is insoluble in the solvents, by the ring cleavage reaction by means of this light treatment. Moreover, the heat treatment, which is performed after the light treatment or simultaneously performed with the light treatment, converts the silicon film into one having superior optical and electrical characteristics.

Examples of light sources used in the present invention include low-pressure or high-pressure mercury lamps, deuterium lamps, discharge light of rare gases, such as argon, krypton, and xenon, YAG lasers, argon lasers, carbon dioxide lasers, excimer lasers of XeF, XeCl, XeBr, KrF, KrCl, ArF, and ArCl. These light sources generally have power in a range of 10 to 5,000 W, and a power of 100 to 1,000 W is adequate in the present invention. The wavelengths of these light sources are not limited as long as the light is absorbed in the coating film of the photo-ring-cleavage silicon compound to some extents, and are generally in a range of 170 nm to 600 nm. The use of laser light is particularly preferable in view of conversion efficiency into the polycrystalline silicon film. The temperature for the light treatment is generally in a range of room temperature to 500°C, and can be appropriately determined depending on the semiconductive characteristics of the resulting silicon film.

The present invention will now be described in more detail with reference to the Examples, but should not be limited to these Examples.

In these Examples, the viscosity and the surface tension of each ink composition indicate values at 20°C.

### (EXAMPLE 1)

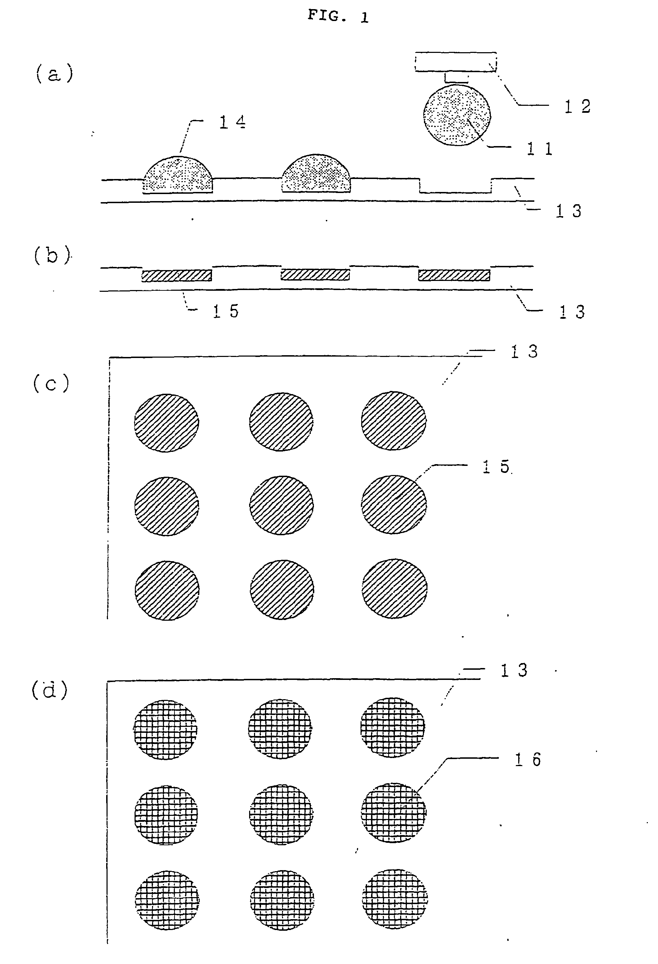

A silicon-compound-containing solution (ink) was prepared by dissolving 0.05 g of cyclopentasilane into a mixed solvent of 7 g of decahydronaphthalene and 3 g of tetrahydronaphthalene. The viscosity of the solution was 3.2 mPa·s and the surface tension was 33 dyn/cm. Fig. 1 shows the patterning of silicon thin films by an ink jet process in accordance with this example. The silicon-compound-containing ink 11 was pattern-coated onto a quartz substrate 13 using an ink jet head 12 composed of a piezoelectric element in an argon atmosphere. The substrate was dried at 200°C in an argon atmosphere and was pyrolyzed at 500°C to form a pattern of metallic silicon films 15 (film regions, each having a diameter of 50 µm), each having a thickness of 35 nm, shown in Figs. 1(b) and 1(c). Fig. 1(b) is a cross-sectional view and Fig. 1(c) is a top view corresponding to Fig. 1(b). A surface analysis of the silicon film by ESCA detected only silicon atoms. The crystal state of the silicon film by a Raman spectrum was 100% amorphous. The amorphous silicon films were irradiated with an excimer laser having a wavelength of 308 nm and an energy density of 300 mJ/cm² in an argon atmosphere to form a pattern of polycrystalline silicon films 16 (film regions, each having a diameter of 50 µm) shown in Fig. 1(d). The Raman spectrum showed that the crystallinity was 80%.

### (EXAMPLE 2)

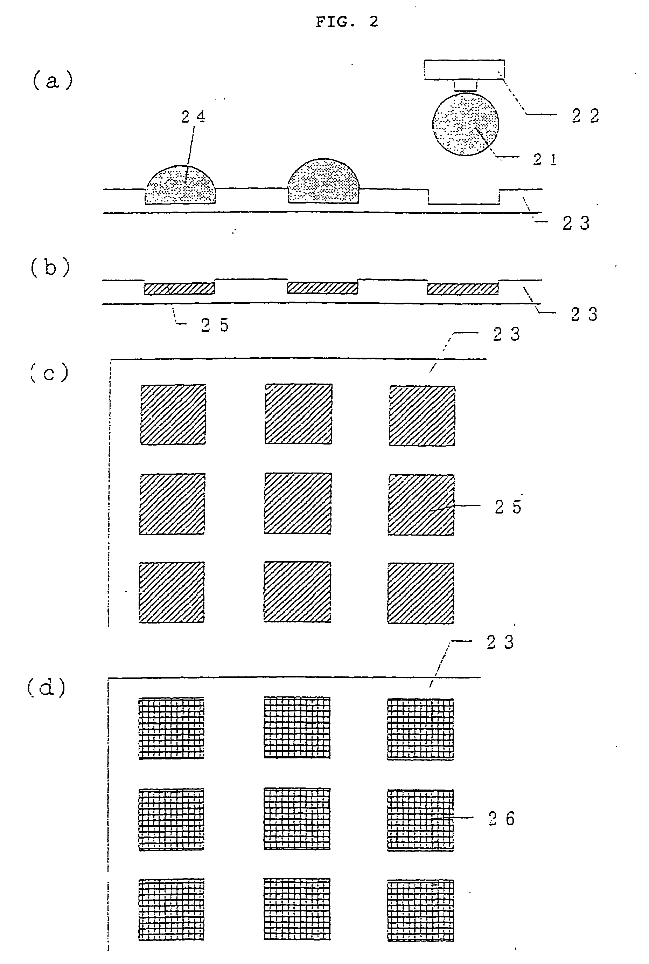

A silicon-compound-containing solution (ink) was prepared by dissolving 0.2 g of hexachlorocyclohexasilane into a mixed solvent of 5 g of cyclohexylbenzene and 5 g of cymene. The viscosity of the solution was 4.8 mPa·s and the surface tension was 32 dyn/cm. Fig. 2 shows the patterning of silicon thin films by an ink jet process in accordance with this example. The silicon-compound-containing ink 21 was pattern-coated onto a quartz substrate 23 using an ink jet head 22 composed of a piezoelectric element in an argon atmosphere. The substrate was dried at 250°C in an argon atmosphere containing 5% hydrogen and was heat-treated at 450°C while being irradiated with ultraviolet light from a 500-W high-pressure mercury lamp for 30 minutes to form a pattern of metallic silicon films 25 (film regions, each being 50 × 50 µm), each having a thickness of 80 nm, shown in Figs. 2(b) and 2(c). A surface analysis of the silicon film by ESCA detected only silicon atoms. The crystal state of the silicon film by a Raman spectrum was 100% amorphous. The amorphous silicon film was heat-treated at 800°C in an argon/hydrogen atmosphere to form a pattern of a polycrystalline silicon film 26 (film region of 50 × 50 µm) having a crystallinity of 50%, shown in Fig. 2(d).

### (EXAMPLE 3)

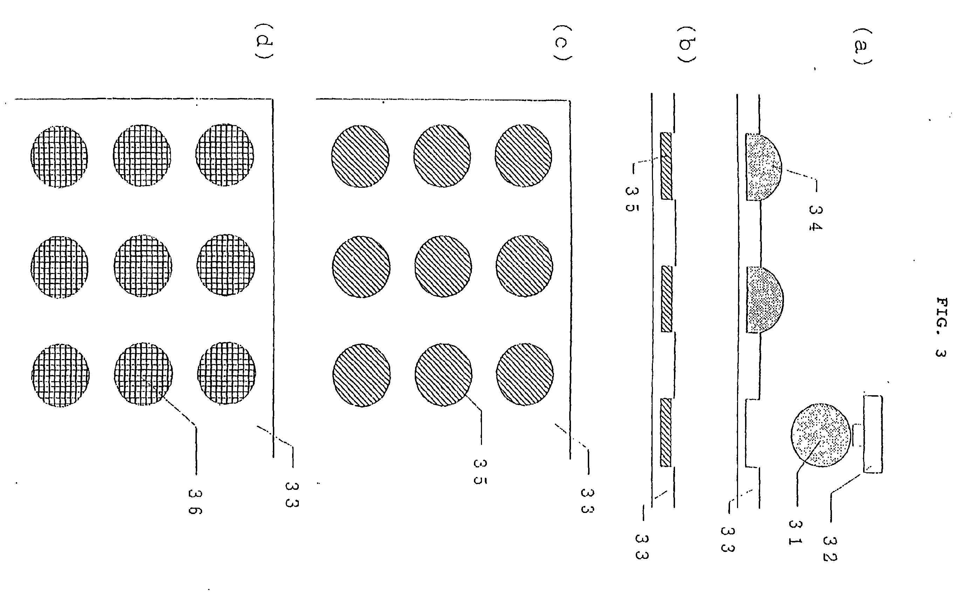

A silicon-compound-containing solution (ink) was prepared by dissolving 0.1 g of 1-borahexaprismane (Compound 11) into a mixed solvent of 7 g of tetrahydronaphthalene and 3 g of cyclohexylbenzene. The viscosity of the solution was 4.2 mPa·s and the surface tension was 36 dyn/cm. Fig. 3 shows the patterning of silicon thin films by an ink jet process in accordance with this example. The silicon-compound-containing ink 31 was pattern-coated onto a quartz substrate 33 using an ink jet head 32 composed of a piezoelectric element in an argon atmosphere. The substrate was dried at 250°C in an argon atmosphere and was pyrolyzed at 500°C to form a pattern of metallic silicon films 35 (film regions, each having a diameter of 50 µm), each having a thickness of 70 nm, shown in Figs. 3(b) and 3(c). A surface analysis of the silicon film by ESCA detected only silicon atoms and boron atoms and the ratio thereof was 5:1. The crystal state of the silicon film by a Raman spectrum was 100% amorphous. The amorphous silicon films were irradiated with an excimer laser having a wavelength of 308 nm and an energy density of 350 mJ/cm² in an argon atmosphere to form a pattern of polycrystalline silicon films 36 (film regions, each having a diameter of 50 µm) shown in Fig. 3(d). The Raman spectrum showed that the crystallinity was 75%.

### (EXAMPLE 4)

A silicon-compound-containing solution (ink) was prepared by dissolving 0.05 g of 1-phosphocyclopentasilane into a mixed solvent of 8 g of decahydronaphthalene and 2 g of cyclohexylbenzene. The viscosity of the solution was 4.0 mPa·s and the surface tension was 36 dyn/cm.

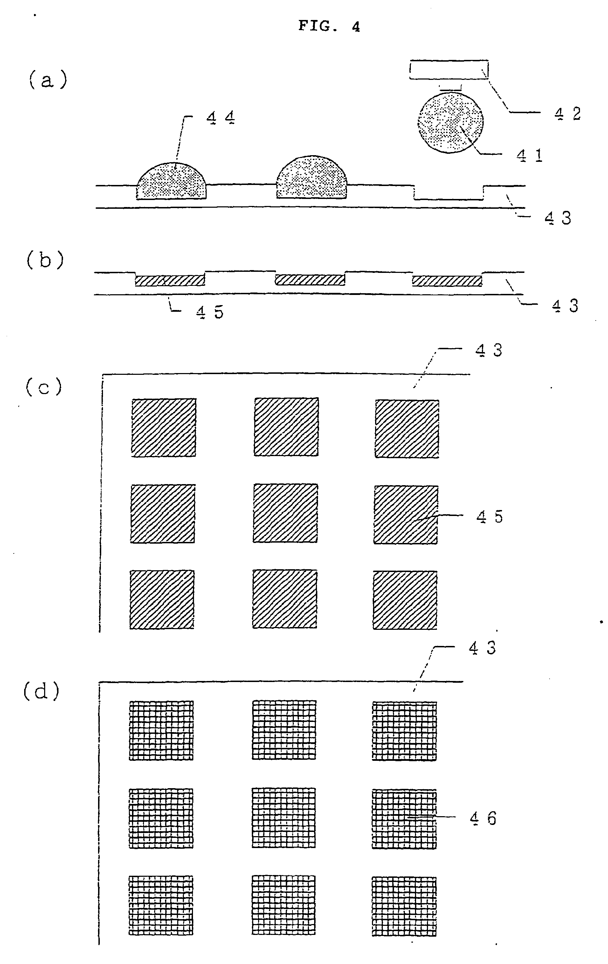

Fig. 4 shows the patterning of silicon thin films by an ink jet process in accordance with this example. The silicon-compound-containing ink 41 was pattern-coated onto a quartz substrate 43 using an ink jet head 42 composed of a piezoelectric element in an argon atmosphere. The substrate was dried at 150°C in an argon atmosphere containing 5% hydrogen while being irradiated with ultraviolet light from a 500-W high-pressure mercury lamp for 10 minutes to form a tough coating film of polysilazane which was insoluble in solvents by a ring cleavage reaction. The coating film was pyrolyzed at 500°C in an argon atmosphere to form a pattern of metallic silicon films 45 (film regions, each being 50 × 50 µm), each having a thickness of 25 nm, shown in Figs. 4(b) and 4(c). A surface analysis of the silicon film by ESCA detected only silicon atoms and phosphorus atoms and the ratio thereof was 5:1. The crystal state of the silicon film by a Raman spectrum was 100% amorphous. The amorphous silicon films were irradiated with an excimer laser having a wavelength of 308 nm and an energy density of 300 mJ/cm² in an argon atmosphere to form a pattern of polycrystalline silicon films 46 (film regions, each being 50 × 50 µm) shown in Fig. 4(d). The Raman spectrum showed that the crystallinity was 75%.

### (EXAMPLE 5)

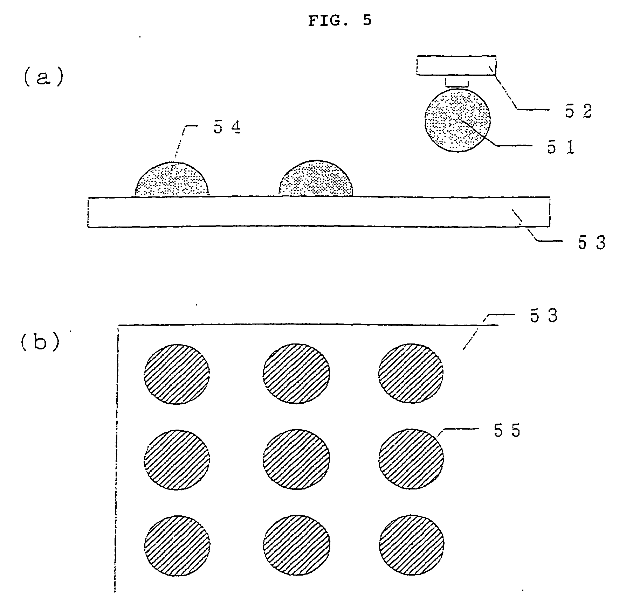

A silicon-compound-containing solution (ink) was prepared by dissolving 0.5 g of silylcyclopentasilane into a mixed solvent of 5 g of decahydronaphthalene and 5 g of tetrahydronaphthalene. The viscosity of the solution was 5.2 mPa·s and the surface tension was 34 dyn/cm. Fig. 5 shows the patterning of silicon thin films by an ink jet process in accordance with this example. The silicon-compound-containing ink 51 was pattern-coated onto a polyimide film substrate 53 using an ink jet head 52 composed of a piezoelectric element in an argon atmosphere. The substrate was dried at 200°C in an argon atmosphere and was irradiated using a 500-W high-pressure mercury lamp at 350°C for photolysis and pyrolysis to form a pattern of metallic silicon films 55 (film regions, each having a diameter of 70 µm), each having a thickness of 80 nm, shown in Fig. 5(b). A surface analysis of the silicon film by ESCA detected only silicon atoms. The crystal state of the silicon film by a Raman spectrum was 100% amorphous.

### (EXAMPLE 6)

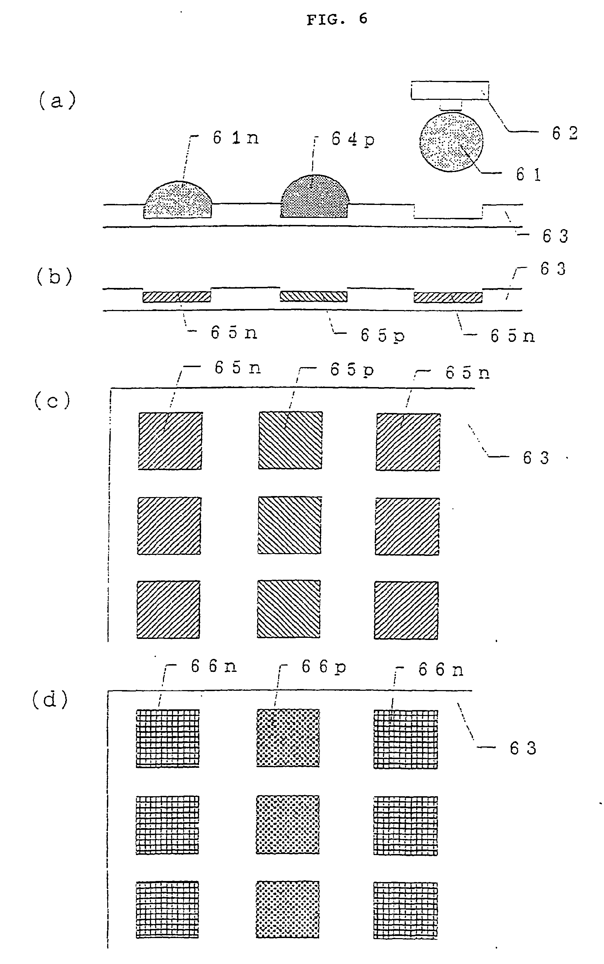

A (p-type) silicon-compound-containing solution (ink) was prepared by dissolving 0.01 g of 1-boracyclopentasilane and 0.1 g of cyclopentasilane into a mixed solvent of 5 g of tetrahydronaphthalene and 5 g of cyclohexylbenzene. The viscosity of the solution was 3.8 mPa·s and the surface tension was 35 dyn/cm. Next, a (n-type) silicon-compound-containing solution (ink) was prepared by dissolving 0.01 g of 1-phosphocyclopentasilane and 0.1 g of cyclopentasilane into a mixed solvent of 5 g of tetrahydronaphthalene and 5 g of cyclohexylbenzene. The viscosity of the solution was 3.7 mPa·s and the surface tension was 36 dyn/cm. Fig. 6 shows the patterning of n-type and p-type silicon thin films by an ink jet process in accordance with this example. The (n-type) silicon-compound-containing ink 61 and the (p-type) silicon-compound-containing ink 64 were pattern-coated onto a quartz substrate 63 using an ink jet head 62 composed of a piezoelectric element in an argon atmosphere. The substrate was dried at 250°C in an argon atmosphere containing 5% hydrogen and was pyrolyzed at 500°C to form a pattern including n-type silicon films 65n (film regions, each being 50 × 50 µm) and p-type silicon films 65p (film regions, each being 50 × 50 µm) shown in Figs. 6(b) and 6(c). According to a surface analysis of the silicon films by ESCA, the ratio of silicon atoms and phosphorus atoms was 50:1 in the n type and the ratio of silicon atoms and phosphorus atoms was 50:1 in the p type. The crystal state of the silicon films by a Raman spectrum was 100% amorphous. The amorphous silicon films were irradiated with an excimer laser having a wavelength of 308 nm and an energy density of 320 mJ/cm² in an argon atmosphere to form a pattern of n-type and p-type polycrystalline silicon films 66n and 66p, respectively, (film regions, each being 50 × 50 µm) shown in Fig. 6(d). The Raman spectrum showed that the crystallinity was 75%.

### (EXAMPLE 7)

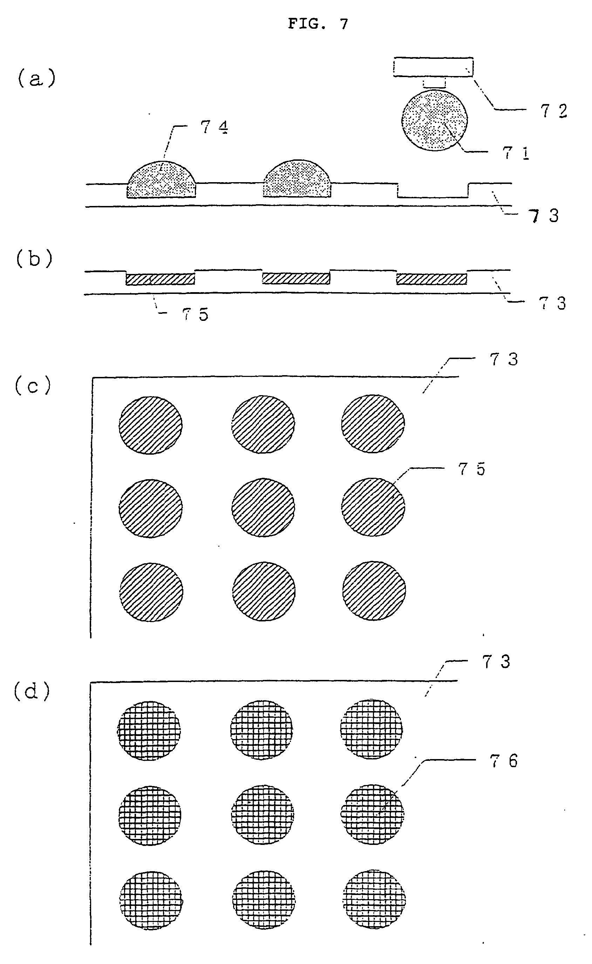

A silicon-compound-containing solution (ink) was prepared by dissolving 0.05 g of octasilacubane (Compound 2) into a mixed solvent of 5 g of decahydronaphthalene and 5 g of tetrahydronaphthalene. The viscosity of the solution was 5.5 mPa·s and the surface tension was 34 dyn/cm. Fig. 7 shows the patterning of silicon thin films by an ink jet process in accordance with this example. The silicon-compound-containing ink 71 was pattern-coated onto a quartz substrate 73 using an ink jet head 72 composed of a piezoelectric element in an argon atmosphere containing 3% hydrogen. The substrate was irradiated with using a high-pressure mercury lamp of 500 W at room temperature for 5 minutes in an argon atmosphere containing 3% hydrogen. As a result, polyhydrosilane films, which were insoluble in solvents, were formed. The films were pyrolyzed in the argon atmosphere containing 3% hydrogen at 500°C to form a pattern of metallic silicon films 75 (film regions, each having a diameter of 50 µm), each having a thickness of 35 nm, shown in Figs. 7(b) and 7(c). Fig. 7(b) is a cross-sectional view and Fig. 7(c) is a top view corresponding to Fig. 7(b). A surface analysis of the silicon film by ESCA detected only silicon atoms. The crystal state of the silicon film by a Raman spectrum was 100% amorphous. The amorphous silicon films were irradiated with an excimer laser having a wavelength of 308 nm and an energy density of 300 mJ/cm² in an argon atmosphere to form a pattern of polycrystalline silicon films 76 (film regions, each having a diameter of 50 µm) shown in Fig. 7(d). The Raman spectrum showed that the crystallinity was 80%.

### (Example 8)

The silicon-compound-containing solution of Example 7 was prepared and was pattern-coated onto a quartz substrate using an ink jet head composed of a piezoelectric element in an argon atmosphere containing 3% hydrogen. The substrate was dried at 150°C in an argon atmosphere containing 3% hydrogen, and simultaneously was irradiated using a 500 W high-pressure mercury lamp for 5 minutes. As a result, polyhydrosilane films, which were insoluble in solvents, were formed. The films were pyrolyzed as in Example 7 to form a pattern of amorphous metallic silicon films, as in Example 7. The amorphous silicon films were irradiated with an excimer laser having the wavelength and the same energy density as these in Example 7 in air to form a pattern of polycrystalline silicon films 76 (film regions, each having a diameter of 50 µm) shown in Fig. 7(d). The Raman spectrum showed that the crystallinity was 60%.

According to the present invention as described above, a composition containing a silicon precursor is pattern-coated by an ink jet process, and a desired silicon film (pattern) as an electronic material can be formed by a novel liquid phase process, which is different from conventional methods for forming silicon film, by means of thermal and/or optical energy.

### INDUSTRIAL APPLICABILITY

Since the present invention prevents the generation of powder during the formation of the silicon film and does not use a large vacuum process, unlike conventional CVD processes, the present invention does not require expensive equipment and can form a film on a substrate having a large area using minimum amounts of materials. Since the silicon film pattern can be formed without a photolithographic etching process, semiconductor devices having silicon films, such as LSIs, thin-film transistors, photoelectric transducers, and photosensitive members, the film patterning process reduces cost and energy consumption.

## Claims

1. A method for forming a silicon film comprising:
applying an ink composition containing a silicon compound onto a substrate by an ink jet process,
**characterized in that**
the silicon composition includes a silicon compound represented by the following general formula:
SiₐX_{b}Y_{c}
wherein X represents a hydrogen atom and/or a halogen atom, Y represents a boron atom or a phosphorus atom, a represents an integer of 3 or more, b represents an integer of a to 2a+c+2, and c represents an integer of 1 to a.

2. A method for forming a silicon film according to claim 1, wherein the ink composition is applied in an inert atmosphere.

3. A method for forming a silicon film according to either claim 1 or 2, further comprising:
after applying the ink composition containing the silicon compound onto the substrate by the ink jet process, a drying step of removing a solvent of the composition and a step of pyrolyzing and/or photolyzing in the coating film.

4. A method for forming a silicon film according to claim 3 further comprising:
a step for irradiating the silicon film formed by the heat treatment and/or the light treatment with a laser to convert the amorphous silicon film into a polycrystalline silicon film.

5. A method for forming a silicon film according to any of claims 1 to 4, wherein a+c is in a range of 5 to 20 in the general formula.

6. A method for forming a silicon film according to any one of claims 1 to 5, wherein the silicon compound in the ink composition is dissolved in at least one solvent having a vapor pressure at room temperature of 0.001 to 50 mmHg.

7. A method for forming a silicon film according to claim 6, wherein the solvent is a hydrocarbon solvent.

8. A method for forming a silicon film according to any one of claims 1 to 7, wherein the concentration of the silicon compound in the composition is in a range of 0.01 to 10 percent by weight.

9. A method for forming a silicon film according to any one of claims 1 to 8, wherein the ink composition has a viscosity of 1 to 50 mPa·s and a surface tension of 20 to 70 dyn/cm.

10. An ink-jet ink composition for forming a silicon film, **characterized in that** the ink jet composition comprises a silicon compound represented by the general formula:
SiₐX_{b}Y_{c}
wherein X represents a hydrogen atom and/or a halogen atom, Y represents a boron atom or a phosphorus atom, a represents an integer of 3 or more, b represents an integer of a to 2a+c+2, and c represents an integer of 1 to a.

11. An ink-jet ink composition for forming a silicon film according to claim 10, wherein
a+c is in a range of 5 to 20 in the general formula.

12. An ink-jet composition according to either claim 10 or 11, wherein the silicon compound is dissolved in at least one solvent having a vapor pressure at room temperature of 0.001 to 50 mmHg.

13. An ink-jet composition according to claim 12, wherein the solvent is a hydrocarbon solvent.

14. An ink-jet composition according to any one of claims 10 to 13, wherein the concentration of the silicon compound in the composition is in a range of 0.01 to 10 percent by weight.

15. An ink-jet composition according to any one of claims 10 to 14, wherein the ink composition has a viscosity of 1 to 50 mPa·s and a surface tension of 20 to 70 dyn/cm.

## Patentansprüche

1. Verfahren zur Herstellung einer Siliziumschicht, umfassend:
Auftragen einer Tintenzusammensetzung, die eine Siliziumverbindung enthält, auf ein Substrat durch ein Tintenstrahlverfahren,
**dadurch gekennzeichnet, dass**
die Siliziumzusammensetzung eine Siliziumverbindung enthält, die durch die folgende allgemeine Formel dargestellt ist:
SiₐX_{b}Y_{c}
wobei X ein Wasserstoffatom und/oder ein Halogenatom darstellt, Y ein Boratom oder ein Phosphoratom darstellt, a eine ganze Zahl von 3 oder mehr darstellt, b eine ganze Zahl von a bis 2a+c+2 darstellt und c eine ganze Zahl von 1 bis a darstellt.

2. Verfahren zur Herstellung einer Siliziumschicht nach Anspruch 1, wobei die Tintenzusammensetzung in einer inerten Atmosphäre aufgetragen wird.

3. Verfahren zur Herstellung einer Siliziumschicht nach Anspruch 1 oder Anspruch 2, des Weiteren umfassend:
nach dem Auftragen der Tintenzusammensetzung, die die Siliziumverbindung enthält, auf das Substrat durch das Tintenstrahlverfahren einen Trocknungsschritt zum Entfernen eines Lösemittels der Zusammensetzung, und einen Pyrolisierungsschritt und/oder Photolysierungsschritt in dem Beschichtungsfilm.

4. Verfahren zur Herstellung einer Siliziumschicht nach Anspruch 3, des Weiteren umfassend:
einen Schritt zum Bestrahlen der gebildeten Siliziumschicht durch Wärmebehandlung und/oder Lichtbehandlung mit einem Laser, um die amorphe Siliziumschicht in eine polykristalline Siliziumschicht umzuwandeln.

5. Verfahren zur Herstellung einer Siliziumschicht nach einem der Ansprüche 1 bis 4, wobei a+c in einem Bereich von 5 bis 20 in der allgemeinen Formel liegt.

6. Verfahren zur Herstellung einer Siliziumschicht nach einem der Ansprüche 1 bis 5, wobei die Siliziumverbindung in der Tintenzusammensetzung in mindestens einem Lösemittel mit einem Dampfdruck bei Raumtemperatur von 0,001 bis 50 mmHg gelöst ist.

7. Verfahren zur Herstellung einer Siliziumschicht nach Anspruch 6, wobei das Lösemittel ein Kohlenwasserstofflösemittel ist.

8. Verfahren zur Herstellung einer Siliziumschicht nach einem der Ansprüche 1 bis 7, wobei die Konzentration der Siliziumverbindung in der Zusammensetzung in einem Bereich von 0,01 bis 10 Gewichtsprozent liegt.

9. Verfahren zur Herstellung einer Siliziumschicht nach einem der Ansprüche 1 bis 8, wobei die Tintenzusammensetzung eine Viskosität von 1 bis 50 mPa·s und eine Oberflächenspannung von 20 bis 70 Dyn/cm hat.

10. Tintenstrahltintenzusammensetzung zur Herstellung einer Siliziumschicht, **dadurch gekennzeichnet, dass** die Tintenstrahlzusammensetzung eine Siliziumverbindung umfasst, die durch die folgende allgemeine Formel dargestellt ist:
SiₐX_{b}Y_{c}
wobei X ein Wasserstoffatom und/oder ein Halogenatom darstellt, Y ein Boratom oder ein Phosphoratom darstellt, a eine ganze Zahl von 3 oder mehr darstellt, b eine ganze Zahl von a bis 2a+c+2 darstellt und c eine ganze Zahl von 1 bis a darstellt.

11. Tintenstrahltintenzusammensetzung zur Herstellung einer Siliziumschicht nach Anspruch 10, wobei
a+c in einem Bereich von 5 bis 20 in der allgemeinen Formel liegt.

12. Tintenstrahltintenzusammensetzung nach Anspruch 10 oder 11, wobei die Siliziumverbindung in mindestens einem Lösemittel mit einem Dampfdruck bei Raumtemperatur von 0,001 bis 50 mmHg gelöst ist.

13. Tintenstrahltintenzusammensetzung nach Anspruch 12. wobei das Lösemittel ein Kohlenwasserstofflösemittel ist.

14. Tintenstrahltintenzusammensetzung nach einem der Ansprüche 10 bis 13, wobei die Konzentration der Siliziumverbindung in der Zusammensetzung in einem Bereich von 0,01 bis 10 Gewichtsprozent liegt.

15. Tintenstrahltintenzusammensetzung nach einem der Ansprüche 10 bis 14, wobei die Tintenzusammensetzung eine Viskosität von 1 bis 50 mPa·s und eine Oberflächenspannung von 20 bis 70 Dyn/cm hat.

## Revendications

1. Procédé pour former une pellicule de silicium comprenant :
l'application d'un mélange d'encre contenant un composé de silicium sur un substrat grâce à un procédé de jet d'encre,
**caractérisé en ce que**
le mélange de silicium comprend un composé de silicium représenté par la formule générale suivante :
SiₐX_{b}Y_{c}
où X représente un atome d'hydrogène et/ou un atome d'halogène, Y représentant un atome de bore ou un atome de phosphore, a représentant un entier de 3 ou plus, b représentant en entier de a à 2a+c+2, et c représentant un entier de 1 à a.

2. Procédé de formation d'une pellicule de silicium selon la revendication 1, le mélange d'encre étant appliqué dans une atmosphère inerte.

3. Procédé pour former une pellicule de silicium selon l'une quelconque des revendications 1 ou 2, comprenant par ailleurs :
après l'application du mélange d'encre contenant le composé de silicium sur le substrat grâce au procédé de jet d'encre, une étape de séchage consistant à enlever un solvant du mélange et une étape de pyrolyse et/ou de photolyse de la pellicule de revêtement.

4. Procédé pour former une pellicule en silicium selon la revendication 3, comprenant par ailleurs :
une étape pour irradier la pellicule de silicium formée grâce au traitement thermique et/ou au traitement lumineux avec un laser pour convertir la pellicule de silicium amorphe en une pellicule de silicium polycristalline.

5. Procédé pour former une pellicule de silicium selon l'une quelconque des revendications 1 à 4, a+c se situant dans une plage de 5 à 20 dans la formule générale.

6. Procédé pour former une pellicule de silicium selon l'une quelconque des revendications 1 à 5, le composé de silicium dans le mélange d'encre étant dissout dans au moins un solvant ayant une pression de vapeur à température ambiante de 0,001 à 50 mmHg.

7. Procédé pour former une pellicule de silicium selon la revendication 6, le solvant étant un solvant d'hydrocarbure.

8. Procédé pour former une pellicule de silicium selon l'une quelconque des revendications 1 à 7, la concentration du composé de silicium dans le mélange se situant dans la plage de 0,01 à 10 pour cent en poids.

9. Procédé pour former une pellicule de silicium selon l'une quelconque des revendications 1 à 8, le mélange d'encre présentant une viscosité de 1 à 50 mPa.s et une tension superficielle de 20 à 70 dyn/cm.

10. Mélange d'encre de jet d'encre pour former une pellicule de silicium, **caractérisé en ce que** le mélange de jet d'encre comprenne un composé de silicium représenté par la formule générale :
SiₐX_{b}Y_{c}
où X représente un atome d'hydrogène et/ou un atome d'halogène, Y représentant un atome de bore ou un atome de phosphore, a représentant un entier de 3 ou plus, b représentant en entier de a à 2a+c+2, et c représentant un entier de 1 à a.

11. Mélange d'encre de jet d'encre pour former une pellicule de silicium selon la revendication 10, où a+c se situe dans la plage de 5 à 20 dans la formule générale.

12. Mélange d'encre de jet d'encre selon l'une quelconque des revendications 10 ou 11, le mélange de silicium étant dissout dans au moins un solvant ayant une pression de vapeur à température ambiante de 0,001 à 50 mmHg.

13. Mélange d'encre de jet d'encre selon la revendication 12, le solvant étant un solvant d'hydrocarbure.

14. Mélange d'encre de jet d'encre selon l'une quelconque des revendications 10 à 13, la concentration du composé de silicium dans le mélange se situant dans une plage de 0,01 à 10 pour cent en poids.

15. Mélange d'encre de jet d'encre selon l'une quelconque des revendications 10 à 14, le mélange d'encre présentant une viscosité de 1 à 50 mPa.s et une tension superficielle de 20 à 70 dyn/cm.
